# EUROPEAN PATENT APPLICATION

(11) **EP 1 892 827 A1**
(43) Date of publication of application: **27.02.2008**
(21) Application number: 06300889.0
(22) Date of filing: 24.08.2006
(51) Int. Cl.: H03F 1/02

(54) **Single-band multi-standard power amplifier**

(71) Applicant: Alcatel Lucent, 75008 Paris (FR)
(72) Inventor: Wiegner, Dirk, 71409 Schwaikheim (DE); Nass, Tobias, 70435 Stuttgart-Zuffenhausen (DE)
(74) Representative: Schneider, Sandra

(57) **Abstract**

The present invention relates to a single-band multi-standard power amplifier module (10) for amplifying a radio frequency signal within a predetermined frequency band, comprising a driver amplifier (12) and a final amplifier (14), a first biasing unit (22) for biasing the driver amplifier (12), a second biasing unit (24) for biasing the final amplifier (14) and a switching unit (30) for selectively by-passing the final amplifier (14). The invention further relates to a transmitter comprising said single-band multi-standard power amplifier, a base or mobile station comprising said transmitter and a method for operating said single-band multi-standard power amplifier module.

## Description

### BACKGROUND OF THE INVENTION

The present invention relates to a single-band multi-standard power amplifier module for amplifying a radio frequency signal. The invention further relates to a base or mobile station for mobile communication and a transmitter comprising a single-band multi-standard power amplifier module. Furthermore the invention relates to a method for operating a single-band multi-standard power amplifier.

In mobile communications there will increasingly co-exist different communication standards within the same band and/or adjacent frequency bands using different modulation schemes. GSM (Global System for Mobile communication) and UMTS (Universal Mobile Telecommunication System) are examples for different communication standards using different modulation schemes. The use of different modulation schemes leads to different peak-to-average ratios (PAR) of the signals. GSM signals for example have a constant envelope and thus a PAR of 0 dB. UMTS on the other hand uses W-CDMA (Wideband Code Division Multiple Access) signals with a varying signal envelope and thus a PAR of e. g. 10,5 dB in case of an unclipped single-carrier W-CDMA signal.

Multi-standard capable base stations or mobile stations have to cover different communication standards in the same or in different frequency bands. Thus, there is need for multi-standard capable transmitters for mobile communications, which are able to provide different, communication standard related peak output power levels in order to achieve the required average output power level. The following examples are given for the GSM and UMTS standards. GSM signals have a PAR of 0 dB. The power amplifier module of a transmitter for GSM therefore has to provide a peak output power level of for example approximately 50 W in order to achieve an average output power level of 50 W. W-CDMA signals in case of UMTS have a PAR of for example 10,5 dB in case no linearization and no clipping is used. The power amplifier module of a transmitter for UMTS therefore has to provide a peak output power level of for example approximately 500 W in order to achieve an average output power level of 50 W.

In order to address both standards by the same multi-standard transmitter, the commonly used amplifier module has to be designed for e. g. 500 W peak output power for UMTS signals without clipping and linearization. If the amplifier module is operated in GSM mode, a peak output power of only approximately 50 W is required. In this case the amplifier module is driven with a big back-off of approx. 10.5 dB, which leads to drastically reduced efficiency.

### OBJECT OF THE INVENTION

It is an object of the invention to provide a multi-standard power amplifier module, transmitter and base or mobile station with suitable power adaptation and increased efficiency.

It is also an object of the invention to provide a method for operating a multi-standard power amplifier with suitable power adaptation and increased efficiency.

### SUMMARY OF THE INVENTION

These objects, and others that appear below, are achieved by a power amplifier module according to claim 1, a corresponding transmitter according to claim 9, a corresponding base or mobile station according to claim 10 and a method according to claim 11.

According to a first aspect of the invention, the final amplifier of the amplifier module can be selectively by-passed using a switching unit. The power amplifier module is adapted to amplifying radio signals within a predetermined frequency band, e.g. up to 300 MHz in the 1 GHz frequency range. By-passing the final amplifier means that the signal passing through the power amplifier module is amplified by the driver amplifier preceding the switching unit. The switching unit then routes the signal through a path not containing the final amplifier, resulting in a by-pass of the final amplifier with the effect that the signal is not passed through the final amplifier. This mode of operation can for example be used when a GSM signal has to be amplified, which requires a lower peak output power. For signals with a higher required peak output power, the switching unit routes the signal through a path which contains the final amplifier. As a result the signal is amplified by the final amplifier as well and the higher required output power is provided.

According to one preferred embodiment of the invention, when by-passing the final amplifier, the switching unit routes the signal through a path which connects the switching unit directly to the output of the power amplifier module, resulting in a by-pass of the final amplifier with the effect that the signal is not passed through the final amplifier and with the further result that the driver amplifier is the last amplifier in the amplifier chain before the output of the power amplifier module.

According to a further aspect of the invention, the driver amplifier and the final amplifier are biased to optimize the performance of the power amplifier module for the addressed communication standards. Optimization may concern e.g. supply voltage adaptation to adjust output power, improve efficiency and/or gain characteristics of the driver amplifier and/or the final amplifier. If the final amplifier is by-passed for example, the supply voltage of the final amplifier can be set to 0 for efficiency reasons.

As can be seen in the foregoing description of the invention, the inventive power amplifier module offers the possibility to adjust the output power level for different communication standards in the same frequency band while maintaining optimized efficiency of the power amplifier module.

In a preferred embodiment of the power amplifier module the switching unit comprises a first power switch at the input of the switching unit. The power switch has an input port, two switchable radio frequency (RF) blocks and at least two output ports. Each of the switchable RF blocks is connected to an output port of the power switch. The switchable RF block blocks signals in a predetermined frequency band. The power switch is controlled to block signals in said predetermined frequency band in all but one of the at least two output ports. In case there are exactly two output ports, signals in said predetermined frequency band are blocked in exactly one output port. The power switch addresses the same frequency band for both output ports. Both RF blocks are therefore designed for the same frequency band. The power switch is therefore able to route signals within a predetermined frequency band to exactly one of its at least two output ports. The signal within said predetermined frequency band is blocked at the other output. Each of the at least two output ports of the power switch is connected to one of the first and second output paths of the switching unit. The final amplifier of the power amplifier module is arranged in the second output path of the power switch. By routing the signal through the first output path, said final amplifier can be by-passed.

In a preferred embodiment of the invention the switching unit comprises a second inverse used power switch arranged at the output of the switching unit. The second power switch is arranged after the first and second output paths of the power switch and switches the first and second output paths to a common output signal path of the switching unit.

In a further preferred embodiment of the invention, an optional amplifier is arranged within the first output path of the power switch. A signal by-passing the final amplifier is then amplified by the optional amplifier. This optional amplifier could for example have a lower output power than the final amplifier and facilitates an appropriate standard related design of the power amplifier module. The optional amplifier can be biased to optimize its performance for the addressed communication standards. Optimization may concern output power, efficiency aspects and/or improved gain characteristics.

In a preferred embodiment of the invention, the power amplifier module comprises feedback paths from the output to the first and second biasing unit. In this embodiment of the invention biasing of the driver and/or final amplifier is done over the feedback path by suitably analyzing the output signal of the power amplifier module. In further embodiments of the invention, the power amplifier module comprises feedback paths from the output to the third and/or fourth biasing unit. Biasing of the optional amplifier and/or the pre-amplifier is then done over the feedback path by suitably analyzing the output signal of the power amplifier module.

In a further embodiment of the invention, the power amplifier module comprises a look-up table. The necessary biasing conditions of the driver amplifier, final amplifier, optional amplifier and/or pre-amplifier are stored in the look-up table. The first, second, third and/or fourth biasing units use the stored values in the look-up table to optimize biasing of the amplifiers, e.g. related to the currently used standard.

The invention is also realized in a transmitter comprising the inventive power amplifier module. The transmitter can be used for transmission of multi-standard signals contained within the predetermined frequency band. Base stations and/or mobile stations realizing the invention comprise said transmitter. Such base stations and/or mobile stations are capable of providing multi-standard service.

The invention is also realized in operating a power amplifier module as described above, comprising the steps of selectively by-passing the final amplifier depending on the output power level of the signal required by the communication standard and adjusting the bias of the driver amplifier and the final amplifier according to required signal characteristics in order to enhance gain characteristics and/or efficiency.

### BRIEF DESCRIPTION OF THE DRAWINGS

Other characteristics and advantages of the invention will appear on reading the following description of a preferred embodiment given by way of non-limiting illustrations, and from the accompanying drawings.
- Fig. 1: shows a schematic overview of an inventive single-band multi-standard power amplifier module,
- Fig. 2: shows a schematic circuit diagram of a switchable RF block and
- Fig. 3: shows a switching unit comprising a power switch and a second inverse used power switch.

### DETAILED DESCRIPTION OF THE INVENTION

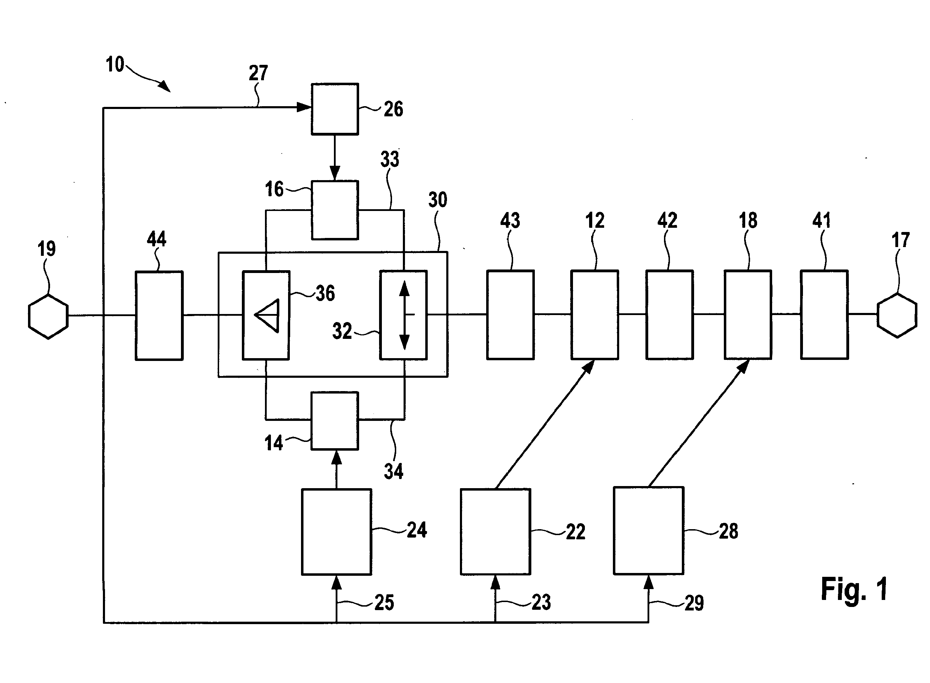

Fig.1 shows a schematic overview of a power amplifier module 10 according to the present invention.

The amplifier module comprises three amplifier stages between input 17 and output 19: a pre-amplifier 18 stage, followed by a driver amplifier 12 stage and a final amplifier 14 stage. Input matching is realized in the input matching network 41, inter-stage matching is performed in the inter-stage matching networks 42 and 43 and output matching is realized in the output matching network 44.

The final amplifier 14 stage is realized with a stage by-passing principle. The signal is either switched to path 33 or to path 34 by the switching unit 30. When switched to path 33, the final amplifier 14 is by-passed. Optionally an optional amplifier 16 can be contained in path 33. The optional amplifier 16 can for example be an amplifier which offers a lower output power than the final amplifier 14, if required for a more appropriate standard related design. The switching unit 30 comprises a first power switch 32 at the input 37 of the switching unit 30 and an inverse used second power switch 36 at the output 38 of the switching unit 30.

Biasing of the amplifiers 12, 14, 16 and /or 18 is done using the biasing units 22, 24, 26, 28 respectively. Biasing is either done using stored values in a look-up table or by suitably analyzing the output signal of the power amplifier module at output port 19 over feedback paths 23, 25, 27, 29, respectively. In a case, when Field Effect Transistors (FET) are used as amplifiers, e. g. the gate and drain voltage can be adapted to achieve a suitable bias.

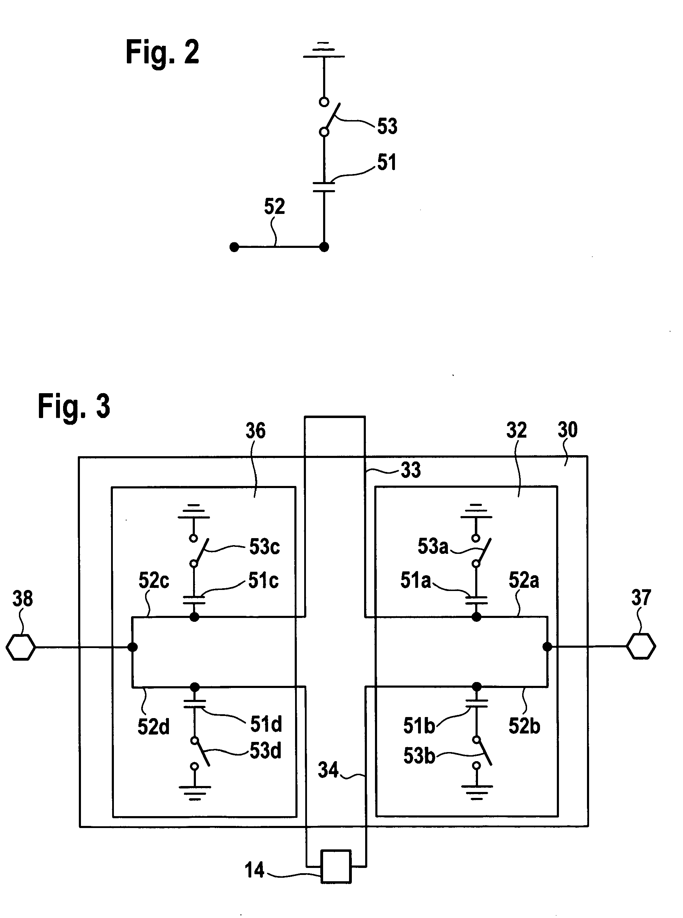

Fig. 2 shows a schematic circuit diagram of an example of a switchable RF block for blocking the frequency band. A capacitor 51 in combination with a quarter wave section comprising a line section 52 results into an inductive behavior of the RF block, which is responsible for the RF blocking character of the RF block concerning RF signals of a certain frequency. By serial connection of a switching element 53, e. g. a PIN diode or RF relay, with the capacitor 51, the RF block becomes switchable. If the switching element 53 is closed (switched on) the RF block is active as to block signals of a predetermined frequency band which depends on the length of the quarter wave section 52. The length of the quarter wave section 52 is matched to a predetermined frequency band in order to block incoming signals in said selected frequency band. Therefore signals of different predetermined frequency bands can be RF blocked by varying the length of the quarter wave section 52. The capacitor 51 is optional. If e. g. relays or DC decoupled switching elements are used as a switching element 53, the functionality of the switchable RF block can also be fulfilled without a capacitor 53. The switchable RF block acts as short/open and is transformed by impedance inversion caused by the quarter wave line section into an open/short.

Fig. 3 shows the switching unit 30 realizing the stage by-passing principle of the power amplifier module 10. The switching unit 30 comprises a power switch 32 at the input 37 of the switching unit 30 and an inverse used second power switch 36 at the output 38 of the switching unit 30. Power switch 32 has one input port and two output ports. The input 37 of the switching unit 30 corresponds to the input of the power switch 32. Power switch 32 comprises two switchable RF blocks 51 a, 52a, 53a and 51 b, 52b, 53b for blocking the frequency band. The first output of the power switch 32 is connected to the inverse used power switch 36 by a direct transmission line 33. The second output of the power switch 32 is connected to the inverse used power switch 36 by transmission line 34, including the final amplifier, e. g. a power transistor, and necessary matching networks. The output 38 of the switching unit 30 corresponds to the output of the power switch 36. Power switch 36 comprises two switchable RF blocks 51 c, 52c, 53c and 51 d, 52d, 53d for blocking the frequency band. Power switches 32 and 36 address the same frequency band for both paths 33 and 34. The quarter wave sections 52a, 52b, 52c and 52d are therefore equal for all four RF blocks. The signal is directed either through path 33, the path by-passing the final amplifier 14, or through path 34, the path using the final amplifier 14. Only one of the paths 33 and 34 is used at a time, in order to realize selective stage by-passing of the final amplifier 14.

An highly preferred operation of the inventive multi-standard power amplifier will be described for a GSM/UMTS multi-standard example. The predetermined frequency band addressed by the switching unit could for example be 700 MHz to 1 GHz. In case of GSM operation, the final amplifier 14 will be by-passed - this means that path 33 is active - by suitably switching the switching elements 53a, 53b, 53c and 53d within the power switches 32 and 36. In this case the switches 53a and 53c are switched off to enable the usage of path 33 and the switches 53b and 53d are switched on to block signals in the predetermined frequency band from passing through path 34. Thus is this case the driver amplifier 12 acts as the last amplifier for GSM mode. In order to adjust the required average output power level and to improve module efficiency, the driver amplifier 12 will be bias adjusted, e. g. gate and drain voltage adjusted for a FET. The final amplifier 14 within the stage by-passing configuration will be turned off, e. g. by a supply voltage of 0 V. The necessary biasing conditions of the driver amplifier 12 can either be stored in a look-up table or determined by suitable analysis of the output signal by using feedback path 23.

If UMTS operation shall be achieved, the final amplifier is necessary in order to achieve the high required peak output power levels, necessary to provide the average output power, due to the high PAR of W-CDMA signals. Thus, path 34 of the stage by-passing configuration will be used by suitably switching the switching elements 53a, 53b, 53c and 53d within the RF blocks of the power switches. In this case the switches 53a and 53c are switched on to block signals in the predetermined frequency band from passing through path 33 and the switches 53b and 53d are switched off to enable the usage of path 34. The biasing of the final amplifier 14 as well as of the driver amplifier 12 can be optimized by use of either a look-up table or adaptive by signal analysis and the use of feedback paths 23 and 25.

In order to achieve the best power amplifier module 10 performance, e. g. from output power and efficiency point of view, for the addressed communication standards, the amplifiers, e. g. transistors, of the different amplifier stages have to be designed suitably. The following example shows possible values for suitably dimensioning the power amplifier module 10 for GSM/UMTS use.

GSM signals have a PAR of 0 dB while W-CDMA signals in case of UMTS have a PAR of 10,5 dB. In order to achieve the required average output power level of 50 W, it is preferable to use at least a amplifier with a maximum of 50 W peak output power as a driver amplifier 12. The final 500 W amplifier 14 is thus not necessary in case of GSM operation. In this case it can be switched off by a supply voltage of 0 V and be bypassed by use of the switching module 30. For this GSM operation the driver amplifier is biased for the 50 W peak output power.

In case of UMTS operation, the required average output power level is also 50 W. The final amplifier 14 providing 500 W peak output power is used in order to achieve the high required peak output power level due to PAR of the W-CDMA signal. A final amplifier 14 providing for example a gain of 14 dB can be chosen. Thus, for this example, an input power level of approximately 20 W, provided by the driver amplifier 12, is necessary. In order to achieve an improved efficiency of the driver transistor for this reduced peak output power level, the biasing of the driver transistor 12 is adjusted suitably.

The example given above has been done for use of an unclipped W-CDMA signal without linearization for the UMTS case. Since clipping and linearization is often used to improve efficiency, in the following example suitable values will be given for dimensioning the power amplifier module 10. The PAR of W-CDMA signals with clipping and linearization is for example reduced down to 6 dB. This leads to a reduced required peak output power of approximately 200 W. In this case, the use of a variable gain amplifier as a pre-amplifier 18 or driver amplifier 12 is recommended. A suitable power input adjustment can also be done in the digital part of the transceiver to improve performance of the power amplifier module. The digital part of the transceiver comprises for example a digital-to-analog converter, algorithms for linearization and/or clipping. The final amplifier 14 can be matched to an ideal 50 Ohms load. An increased performance can be achieved if the final amplifier 14 is matched to the impedance level of the power switches (32), (36) or if the number of RF blocks is increased.

## Claims

1. Single-band multi-standard power amplifier module (10) for amplifying a radio frequency signal within a predetermined frequency band, comprising
a driver amplifier (12) and a final amplifier (14),
a first biasing unit (22) for biasing the driver amplifier (12),
a second biasing unit (24) for biasing the final amplifier (14)
and a switching unit (30) for selectively by-passing the final amplifier(14).

2. Single-band multi-standard power amplifier module (10) according to claim 1, **characterized in that**
the switching unit (30) comprises a first power switch (32) with a first (33) and a second (34) output path, said first power switch (32) being provided for selectively blocking signals in said predetermined frequency band in one of the first (33) and second (34) output paths, and that the final amplifier (14) is arranged after the first power switch (32) in the second output path (34) of said first power switch (32), whereas the first output path (33) of said power switch (32) is provided for by-passing the final amplifier (14).

3. Single-band multi-standard power amplifier module (10) according to claim 2, **characterized in that**
the switching unit further comprises a second power switch (36) which is situated after the final amplifier (14) which suitably directs the RF signal either of path (33) or (34) to an output (19).

4. Single-band multi-standard power amplifier module (10) according to claim 3,
further comprising an optional amplifier (16) being arranged after the first power switch (32) in the first output path (33) of said output switch (32) and a third biasing unit (26) for biasing said optional amplifier (16).

5. Single-band multi-standard power amplifier module (10) according to claim 4, **characterized in that**
said second power switch (36) is situated after the optional amplifier (16).

6. Single-band multi-standard power amplifier module (10) according to claim 3, **characterized by**
a first feedback path (23) from said output (19) of said single-band multi-standard power amplifier module (10) to the first biasing unit (22) and further **characterized by**
a second feedback path (25) from said output (19) of said single-band multi-standard power amplifier module (10) to the second biasing unit (24).

7. Single-band multi-standard power amplifier module (10) according to claim 1,
further comprising a pre-amplifier (18) preceding said driver amplifier (12) and a fourth biasing unit (28) for biasing said pre-amplifier (18).

8. Single-band multi-standard power amplifier module (10) according to claim 7,
**characterized in that**
said first (22), said second (24) and/or said fourth (28) biasing unit is connected to a look-up table to optimize biasing.

9. Transmitter for mobile communications comprising a single-band multi-standard power amplifier module (10) according to claim 1.

10. Base station or mobile station comprising a transmitter according to claim 9.

11. Method of operating a single-band multi-standard power amplifier module (10) according to claim 1, comprising the steps of:
selectively by-passing the final amplifier (14) depending on the required output power level of the signal and
adjusting the bias of the driver amplifier (22)and the final amplifier (14) according to required signal characteristics.
